# EUROPEAN PATENT APPLICATION

(11) **EP 3 757 862 A1**
(43) Date of publication of application: **30.12.2020**
(21) Application number: 20175895.0
(22) Date of filing: 21.05.2020
(51) Int. Cl.: G06F 30/20, G06F 30/00, G06F 111/10

(54) **MAGNETIC FIELD SIMULATOR METHOD, MAGNETIC FIELD SIMULATOR PROGRAM AND CORRESPONDING INFORMATION PROCESSING APPARATUS**

(30) Priority: 28.06.2019 JP 2019120849
(71) Applicant: FUJITSU LIMITED, Kanagawa 211-8588 (JP)
(72) Inventor: SHIMIZU, Koichi, Kawasaki-shi, Kanagawa 211-8588 (JP)
(74) Representative: Haseltine Lake Kempner LLP

(57) **Abstract**

An information processing apparatus includes an input unit configured to input data of major loop regarding a hysteresis of a magnetic body, data of an initial magnetization curve of the magnetic body, and a relationship between a maximum magnetic flux density of a minor loop regarding the hysteresis and an area of the minor loop associated with the magnetic flux density; and a generation unit configured to generate data of a plurality of the minor loops using the data of the major loop, the initial magnetization curve, and the relationship between the maximum magnetic flux density of the minor loop regarding the hysteresis and the area of the minor loop associated with the magnetic flux density which have been input by the input unit.

## Description

### FIELD

The embodiment discussed herein is an information processing apparatus, a magnetic field simulator method, and a magnetic field simulator program.

### BACKGROUND

A technology for a magnetic field analysis using a finite element method has been proposed. The finite element method mentioned herein refers to a calculation method of dividing a magnetic body set as an analysis target into a mesh on a computer, creating an equation that governs magnetic field physics with respect to unknowns arranged on points and sides of the mesh, and solving simultaneous equations of the entire analysis target to find a solution.

To calculate a magnetic loss using the finite element method, a calculation where a magnetic hysteresis is taken into account for various meshes is to be performed. A calculation method of taking into account the magnetic hysteresis includes a method called play model classified into a mathematical model. The play model is a model representing an actually measured BH curve using a plurality of operators where an output is delayed with respect to an input called hysteron. The BH curve does not become a single line and becomes a closed curve surrounding a certain area. In the play model, the magnetic loss using the finite element method is calculated using the above-mentioned BH curve. For example, information on an outer major loop and a plurality of inner minor loops with respect to the major loop is to be input to the play model representing the actually measured BH curve. The actually measured BH curve is also referred to as a magnetic hysteresis curve.

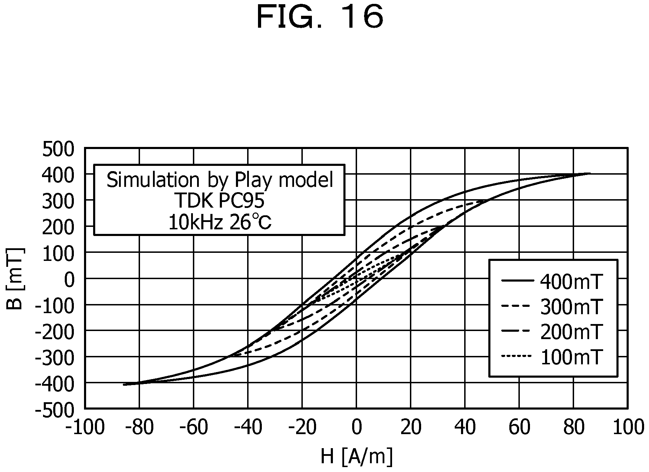

FIG. 16 is a drawing illustrating a reference example of the BH curve (magnetic hysteresis curve). As illustrated in FIG. 16, the actually measured BH curve represented by the play model is represented. In the actually measured BH curve, a graphic representation based on one outer major loop and three inner minor loops is represented.

Data of a major loop of a magnetic body is provided from a manufacturer of the magnetic body in many cases. However, there is hardly any case where data of minor loops is provided from the manufacturer. Since the major loop and the plurality of minor loops are to be used to calculate a magnetic characteristic using the play model, the data on the minor loops is to be measured by an experiment.

As related art, for example, International Publication Pamphlet No. WO 2018/154672, International Publication Pamphlet No. WO 2010/038799, and the like are disclosed.

### SUMMARY

### [TECHNICAL PROBLEM]

However, although the major loop and the plurality of minor loops are to be used to calculate the magnetic characteristic using the play model, an issue occurs that it takes man hours to obtain the data of the minor loops.

The data of the major loop is provided from the manufacturer in many cases, but there is hardly any case where the data of the minor loops is provided from the manufacturer. For example, in many cases, the data of the minor loops is not obtained from the manufacturer. The data of the minor loops is to be measured by an experiment, but to perform the measurement by the experiment, a measurement apparatus is to be used. To perform the measurement by the experiment, it takes manual work man hours and man hours by the measurement.

It is therefore desirable to provide an information processing apparatus, a magnetic field simulator method, and a magnetic field simulator program capable of calculating the minor loops used for calculating the magnetic characteristic using a computer.

### [SOLUTION TO PROBLEM]

According to an embodiment of one aspect, an information processing apparatus includes an input unit configured to input data of major loop regarding a hysteresis of a magnetic body, data of an initial magnetization curve of the magnetic body, and a relationship between a maximum magnetic flux density of a minor loop regarding the hysteresis and an area of the minor loop associated with the magnetic flux density; and a generation unit configured to generate data of a plurality of the minor loops using the data of the major loop, the initial magnetization curve, and the relationship between the maximum magnetic flux density of the minor loop regarding the hysteresis and the area of the minor loop associated with the magnetic flux density which have been input by the input unit.

### BRIEF DESCRIPTION OF DRAWINGS

FIG. 1 is a functional block diagram illustrating a configuration of an information processing apparatus according to an embodiment;
FIG. 2 is a drawing illustrating an example of an actually measured BH curve;
FIG. 3 is a drawing illustrating an example of a Bm-W curve;
FIG. 4 is a drawing illustrating an example of a major loop and an initial magnetization curve;
FIG. 5 is a drawing for describing an outline of minor loop generation processing according to the embodiment (1);
FIG. 6 is a drawing for describing the outline of the minor loop generation processing according to the embodiment (2);
FIG. 7 is a drawing for describing the outline of the minor loop generation processing according to the embodiment (3);
FIG. 8 is a drawing for describing the outline of the minor loop generation processing according to the embodiment (4);
FIG. 9 is a drawing for describing the outline of the minor loop generation processing according to the embodiment (5);
FIG. 10 is a drawing for describing an outline of the minor loop generation processing according to the embodiment (6);
FIG. 11 is a drawing illustrating an example of a flowchart of the minor loop generation processing according to the embodiment;
FIGs. 12A and 12B are drawings illustrating an example of generation processing for N-th minor loop data;
FIG. 13 is a drawing illustrating a BH curve including actually measured minor loops (inner loops);
FIG. 14 is a drawing illustrating a BH curve including minor loops calculated by the minor loop generation processing according to the embodiment;
FIG. 15 is a drawing illustrating an example of a computer that executes a magnetic field simulator program; and
FIG. 16 is a drawing illustrating a reference example of the BH curve (magnetic hysteresis curve).

### [ADVANTAGEOUS EFFECTS OF INVENTION]

According to an embodiment of one aspect, it may be possible to provide an information processing apparatus, a magnetic field simulator method, and a magnetic field simulator program capable of calculating the minor loops used for calculating the magnetic characteristic using a computer.

### DESCRIPTION OF EMBODIMENTS

Hereinafter, an embodiment of an information processing apparatus, a magnetic field simulator method, and a magnetic field simulator program, which are disclosed herein, will be described in detail, by way of example only, with reference to the drawings. This disclosure is not limited by the embodiment.

### [Embodiment]

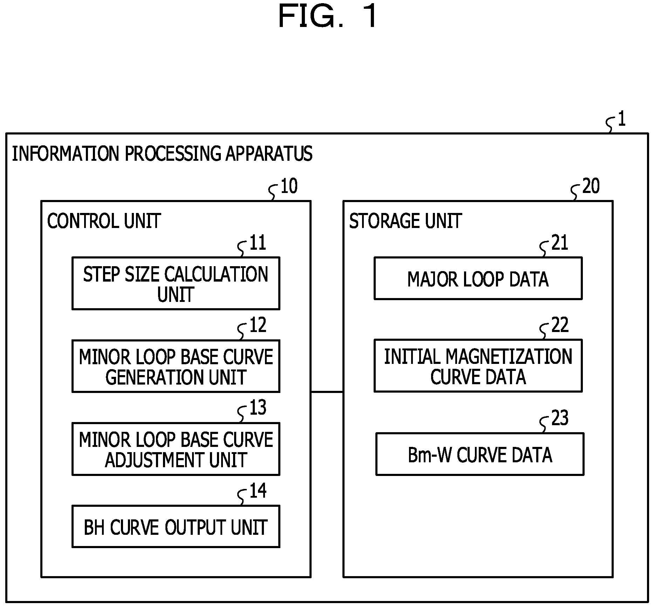

FIG. 1 is a functional block diagram illustrating a configuration of an information processing apparatus according to an embodiment. An information processing apparatus 1 illustrated in FIG. 1 generates data of minor loops using data of a major loop regarding a hysteresis of a magnetic body, an initial magnetization curve, and a relationship between a hysteresis loss (W) with respect to an amplitude (Bm) of a magnetic flux density. The "initial magnetization curve" mentioned herein refers to a curve in which a magnetization behavior in a course where an external magnetic field is monotonically increased from a state of no external magnetic field is represented as a BH curve. Since the initial magnetization curve does not have a course where the external magnetic field is decreased, no hysteresis exists.

As illustrated in FIG. 1, an information processing apparatus 1 includes a control unit 10 and a storage unit 20.

The control unit 10 is an electronic circuit, such as a central processing unit (CPU). The control unit 10 includes an internal memory for storing programs defining various processing procedures and control data, and executes various types of processing using the programs and the data. The control unit 10 includes a step size calculation unit 11, a minor loop base curve generation unit 12, a minor loop base curve adjustment unit 13, and a BH curve output unit 14.

The storage unit 20 is, for example, a semiconductor memory element such as a random-access memory (RAM) or a flash memory, or a storage device such as a hard disk or an optical disk. The storage unit 20 includes major loop data 21, initial magnetization curve data 22, and Bm-W curve data 23.

The major loop data 21 is data of a major loop regarding the hysteresis of the magnetic body. The major loop data 21 is provided from a material manufacturer of the magnetic body, for example.

The initial magnetization curve data 22 is data of the curve in which the magnetization behavior in the course where the external magnetic field is monotonically increased from the state of no external magnetic field is represented as the BH curve. In other words, for example, the initial magnetization curve data 22 is actually measured data of a BH curve in which a value (Bm) at which a magnetic flux density (B) of each of a plurality of minor loops becomes the maximum is linked to a magnetic field (H) when the value is indicated using a straight line. The initial magnetization curve data 22 is provided from the material manufacturer of the magnetic body, for example.

Data of the minor loops is hardly provided from the material manufacturer of the magnetic body. The data of the minor loops may be measured using a measurement apparatus. However, to perform the measurement, it takes manual work man hours and man hours by the measurement. When the data of the minor loops may be obtained by numeric processing by the information processing apparatus 1, the man hours for the work and measurement may be reduced.

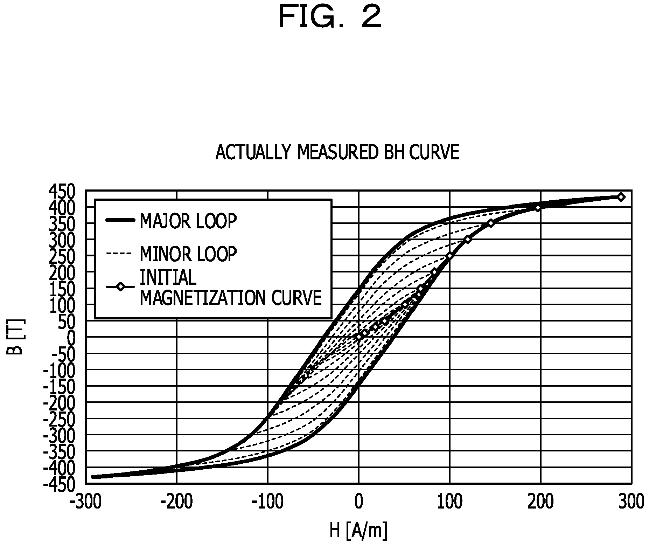

FIG. 2 illustrates an example of the BH curve when the major loop, the initial magnetization curve, and the plurality of minor loops are actually measured. FIG. 2 is a drawing illustrating an example of the actually measured BH curve. The BH curve is a curve indicating a relationship between a magnetic flux density B of the magnetic body and an intensity H of the magnetic field. As illustrated in FIG. 2, a hysteresis loop indicated on an outermost side is the major loop. A BH curve located in the center and linked by the straight light is the initial magnetization curve. Hysteresis loops indicated on an inner side with respect to the major loop are the plurality of minor loops.

With reference to FIG. 1 again, the Bm-W curve data 23 is curve data of a hysteresis loss (W) with respect to an amplitude (Bm) of the magnetic flux density. The amplitude Bm of the magnetic flux density is the maximum magnetic flux density of the minor loops. The hysteresis loss W is a value of the area (= ∫BdH) of the minor loops which is characterized by a value of the amplitude Bm of the magnetic flux density. In the magnetic body having a hysteresis characteristic, a phase of the magnetic flux density B is lagged with respect to the external magnetic field H, and heat is generated from this phase lag. A loss by the aforementioned heat generation is called "hysteresis loss".

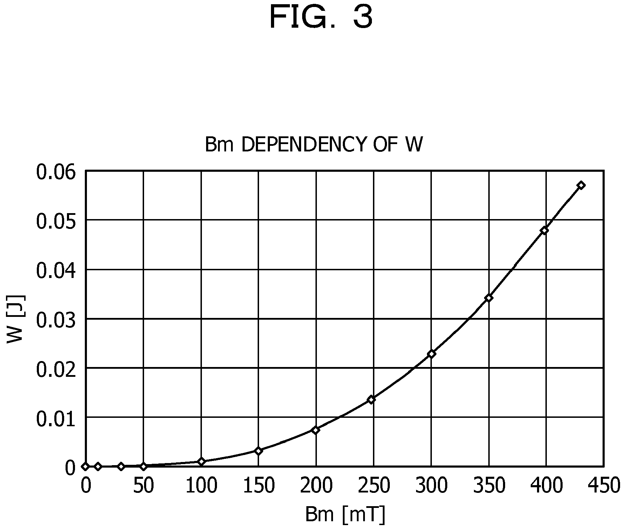

FIG. 3 illustrates an example of the Bm-W curve. FIG. 3 is a drawing illustrating an example of the Bm-W curve. In FIG. 3, the Bm-W curve indicating a relationship between the amplitude Bm of the magnetic flux density and the hysteresis loss W is illustrated. The hysteresis loss W corresponds to a value of the area of the minor loops associated with a value of the amplitude Bm of the magnetic flux density. The Bm-W curve has a feature that the hysteresis loss W is in proportion to an n-th power (n is 2 to 3) of the amplitude Bm of the magnetic flux density. When no Bm-W curve exists, it is sufficient when a value of n is input, and a curve generated using the input value of n is used as a substitute as the Bm-W curve.

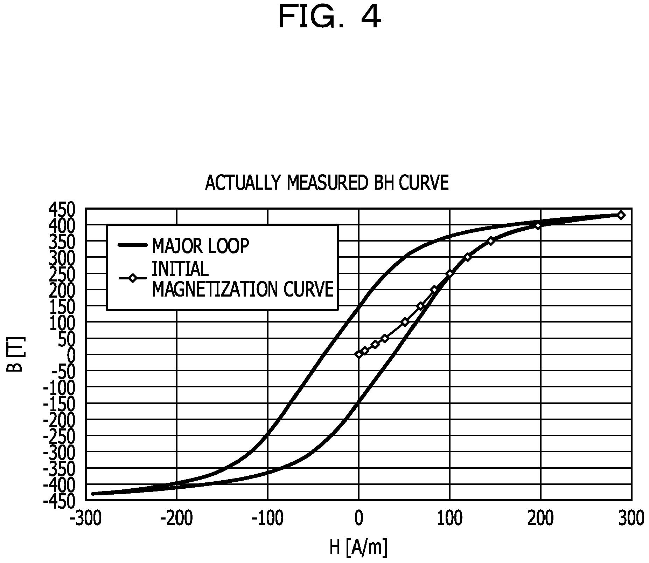

FIG. 4 is a drawing illustrating an example of the major loop and the initial magnetization curve. A graphic representation illustrated in FIG. 4 is a BH curve obtained by removing the actually measured minor loops illustrated in FIG. 2. For example, the graphic representation is actually measured data of the BH curve composed of the major loop and the initial magnetization curve. According to the embodiment, the information processing apparatus 1 generates any number of minor loops using the major loop and the initial magnetization curve illustrated in FIG. 4 and the Bm-W curve illustrated in FIG. 3.

With reference to FIG. 1 again, the step size calculation unit 11 calculates a step size of the magnetic flux density used for generating the minor loops using the maximum magnetic flux density of the major loop data 21. For example, when a plurality of minor loops are generated, the step size calculation unit 11 calculates the step size of the magnetic flux density for determining a value of the maximum magnetic flux density used when each of the minor loops is generated, using the maximum magnetic flux density of the major loop data 21. In one example, the step size calculation unit 11 calculates the step size of the magnetic flux density by dividing a value of the maximum magnetic flux density of the major loop data 21 by a value obtained by adding 1 to the number of minor loops desired to be generated.

The minor loop base curve generation unit 12 generates a curve serving as a base of the minor loops.

For example, the minor loop base curve generation unit 12 generates a minor curve (right minor curve segment) located on a right side in a region where the magnetic flux density is positive. In one example, the minor loop base curve generation unit 12 calculates the maximum magnetic flux density of the minor loops which is obtained by multiplying the step size of the magnetic flux density calculated by the step size calculation unit 11 by an integer. The minor loop base curve generation unit 12 obtains a first point corresponding to the maximum magnetic flux density calculated by the initial magnetization curve data 22 and a second point corresponding to the magnetic flux density of the major loop data 21. The minor loop base curve generation unit 12 moves a curve linking the second point in the major loop data 21 to a point where the magnetic flux density indicates zero in a direction from the second point to the first point in parallel to generate a first base curve (right minor curve segment) of the minor loops.

The minor loop base curve generation unit 12 generates a minor curve (left minor curve segment) located on a left side in the region where the magnetic flux density is positive. In one example, the minor loop base curve generation unit 12 obtains a third point obtained by inverting a value of the magnetic field at a point where the magnetic flux density of the first base curve becomes zero, and a fourth point corresponding to the third point in the major loop data 21. The minor loop base curve generation unit 12 moves a curve linking the fourth point in the major loop data to a point corresponding to a value of the magnetic field at the first point in a direction from the fourth point to the third point in parallel. The minor loop base curve generation unit 12 generates a second base curve (left minor curve segment) of the minor loops by performing an adjustment such that an end-point on an upper side as a result of the parallel movement is matched with the first point.

The minor loop base curve generation unit 12 rotates the first base curve and the second base curve in a point symmetry where an origin is set as a center by 180 degrees to generate a third base curve in a region where the magnetic flux density is negative.

The minor loop base curve adjustment unit 13 adjusts the minor loop base curve such that the area of the closed region obtained from the minor loop base curve becomes an area corresponding to the maximum magnetic flux density of the minor loops. For example, the minor loop base curve adjustment unit 13 obtains the hysteresis loss W associated with the maximum magnetic flux density of the minor loops to be actually generated using the Bm-W curve data 23. For example, the minor loop base curve adjustment unit 13 obtains the area of the minor loops associated with the maximum magnetic flux density from the Bm-W curve data 23. The minor loop base curve adjustment unit 13 obtains the area of the closed region obtained from the minor loop base curve. The minor loop base curve adjustment unit 13 generates the minor loops by expanding or reducing the minor loop base curve in an H (magnetic field) axis direction such that the obtained area becomes the area obtained from the Bm-W curve data 23.

The BH curve output unit 14 outputs a BH curve including the plural pieces of generated minor loop data, the major loop data 21, and the initial magnetization curve data 22.

### [Outline of minor loop generation processing]

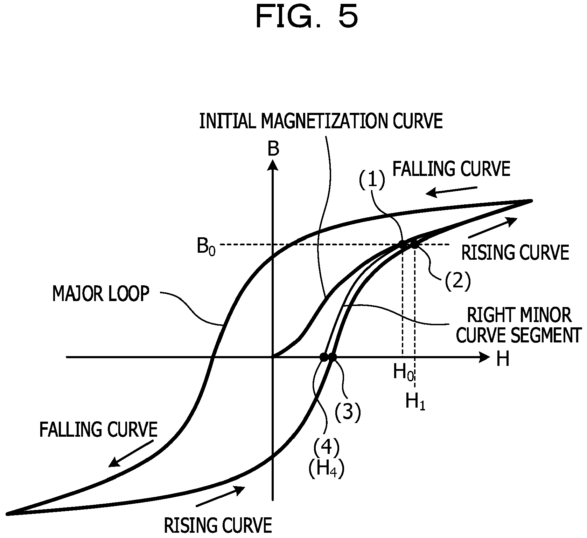

An outline of minor loop generation processing according to the embodiment is described with reference to FIGs. 5 to 10. FIGs. 5 to 10 are drawings for describing the outline of the minor loop generation processing according to the embodiment. A case where one minor loop is generated is described. It is assumed that the step size of the magnetic flux density based on the number of minor loops to be generated is calculated by the step size calculation unit 11.

As illustrated in FIG. 5, the minor loop base curve generation unit 12 generates the right minor curve segment indicating a segment of the right minor curve. For example, the minor loop base curve generation unit 12 calculates a maximum magnetic flux density B₀ of the minor loop which is obtained by multiplying the step size of the magnetic flux density by an integer.

The minor loop base curve generation unit 12 obtains a first point (1) (H₀, B₀) corresponding to the maximum magnetic flux density B₀ calculated by the initial magnetization curve data 22 and a second point (2) (H₁, B₀) corresponding to the magnetic flux density B₀ in the major loop data 21. The minor loop base curve generation unit 12 moves a curve linking the second point (2) (H₁, B₀) in the major loop data 21 to a point (3) where the magnetic flux density B indicates zero in parallel until the second point (2) (H₁, B₀) is overlapped with the first point (1) (H₀, B₀). As a result, the minor loop base curve generation unit 12 sets a curve segment linking the first point (1) to a point (4) as the right minor curve segment (first base curve segment) of the minor loop.

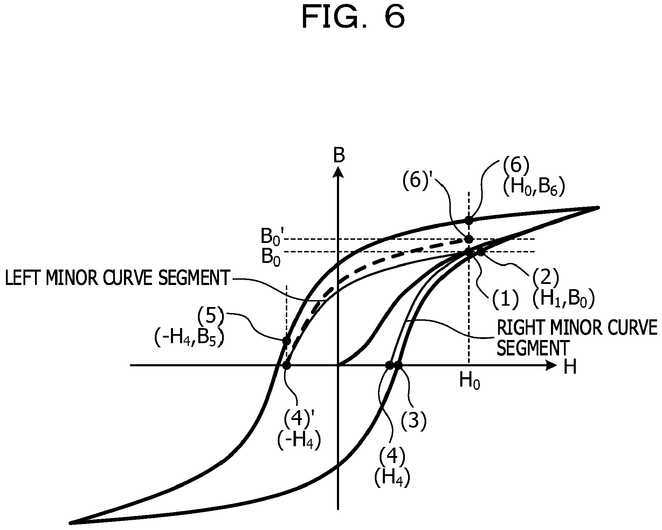

As illustrated in FIG. 6, the minor loop base curve generation unit 12 generates the left minor curve segment indicating a segment of the left minor curve. For example, the minor loop base curve generation unit 12 obtains a third point (4)' (-H₄, 0) obtained by inverting a value of the magnetic field at a point (4) (H₄, 0) where the magnetic flux density of the right minor curve becomes zero. The minor loop base curve generation unit 12 obtains a fourth point (5) (-H₄, B₅) corresponding to the third point (4)' (-H₄, 0) in the major loop data 21. The minor loop base curve generation unit 12 moves a curve linking the fourth point (5) (-H₄, B₅) in the major loop data 21 to a point (6) (H₀, B₆) in parallel to a position where the fourth point (5) (-H₄, B₅) is overlapped with the third point (4)' (-H₄, B₀). A movement destination of the point (6) (H₀, B₆) is set as a point (6)', and the magnetic flux density at the point (6) is set as B₀'. The minor loop base curve generation unit 12 obtains a curve segment linking the point (4)' to the point (1) obtained by multiplying a height of a curve segment linking the point (4)' to the point (6)' indicating a result of the parallel movement by B0/B0'. This is because an adjustment is performed such that the end-point (6)' on the upper side as a result of the parallel movement is matched with the first point (1). As a result, the minor loop base curve generation unit 12 sets the obtained curve segment linking the point (4)' to the point (1) as the left minor curve segment (second base curve segment) of the minor loop.

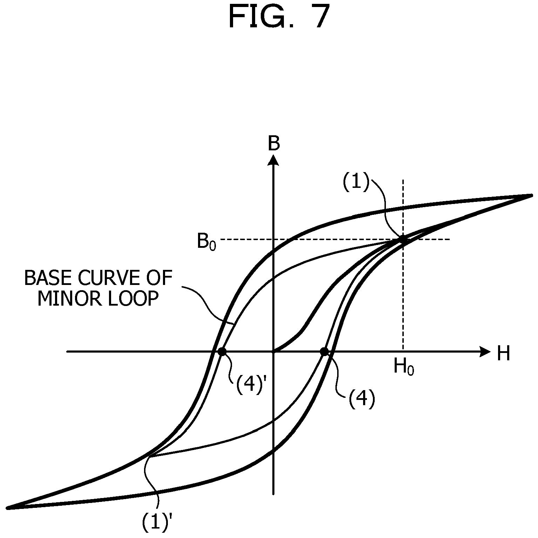

As illustrated in FIG. 7, the minor loop base curve generation unit 12 generates a third base curve segment in a region where the magnetic flux density is negative by rotating the left minor curve segment and the right minor curve segment about the origin by 180 degrees. For example, the minor loop base curve generation unit 12 generates the base curve of the minor loop using the left minor curve segment, the right minor curve segment, and the third base curve segment. The generated base curve of the minor loop becomes a closed curve.

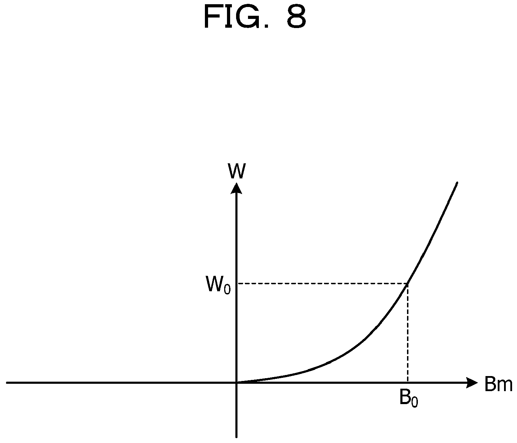

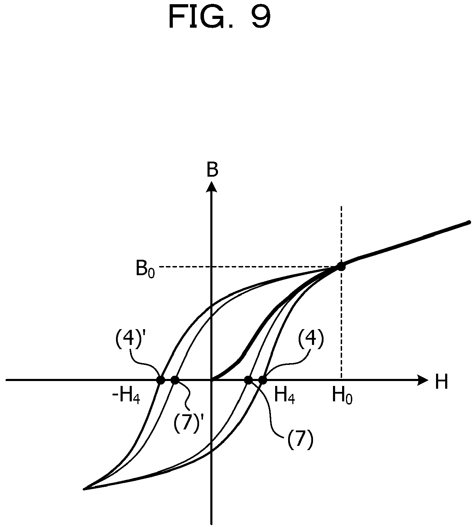

The area W of the base curve of the minor loop is not necessarily on the actually measured Bm-W curve. The minor loop base curve adjustment unit 13 generates the minor loop by expanding or reducing the curve linked to the point (4) and the curve linked to the point (4)' in the H (magnetic field) axis direction such that the area W of the base curve of the minor loop is on the Bm-W curve. Descriptions on minor loop generation will be provided below with reference to FIGs. 8 and 9.

FIG. 8 illustrates the Bm-W curve. In one example, the minor loop base curve adjustment unit 13 obtains a hysteresis loss W0 corresponding to a maximum magnetic flux density B₀ of the base curve of the minor loop using the Bm-W curve. For example, since the hysteresis loss W₀ corresponds to a value of the area of the minor loop associated with a value of an amplitude B₀ of the magnetic flux density, the minor loop base curve adjustment unit 13 obtains an area W₀ of the base curve of the minor loop using the Bm-W curve.

As illustrated in FIG. 9, the minor loop base curve adjustment unit 13 sets the area of the closed region obtained from the minor loop base curve as W. The minor loop base curve adjustment unit 13 performs an adjustment by expanding or reducing a curve linked to the point (4) and the point (4)' to a curve linked to a point (7) and a point (7)' in the H axis direction such that W becomes W₀. For example, a [distance between the point (7) and the point (7)'] becomes a value obtained by multiplying a [distance between the point (4) and the point (4)'] by W₀/W.

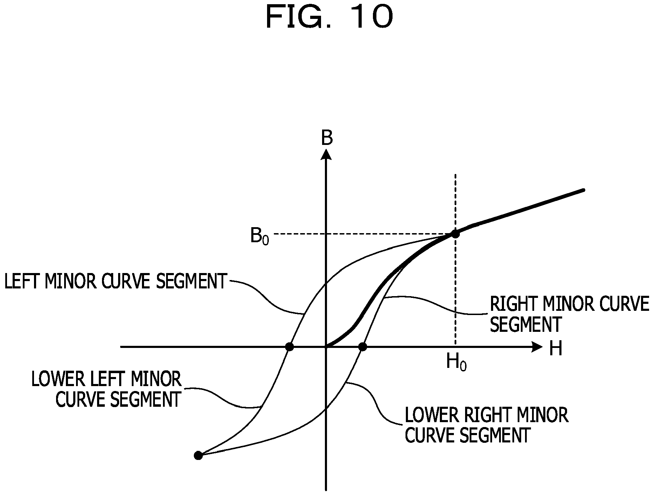

As a result, as illustrated in FIG. 10, the minor loop corresponding to the maximum magnetic flux density B₀ is generated.

### [Flowchart of minor loop generation processing]

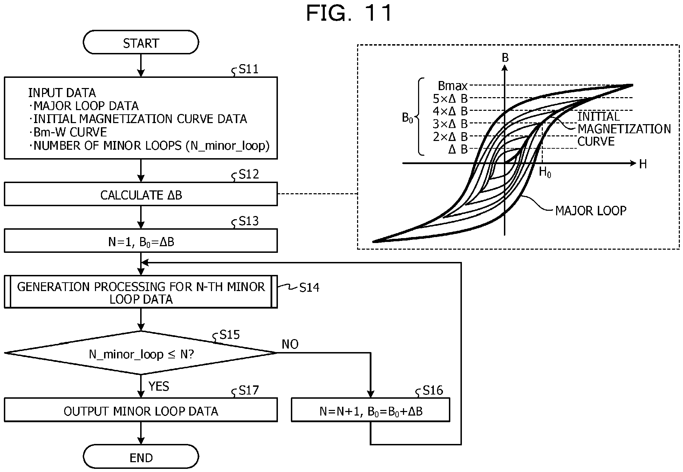

An example of a flowchart of the minor loop generation processing executed by the information processing apparatus 1 is described with reference to FIG. 11. FIG. 11 is a drawing illustrating an example of the flowchart of the minor loop generation processing according to the embodiment. In FIG. 11, descriptions are provided using two-dimensional coordinates in which an x axis is set as the magnetic field H, and a y axis is set as the magnetic flux density B.

As illustrated in FIG. 11, the information processing apparatus 1 inputs various data (S11). The various data include the major loop data 21, the initial magnetization curve data 22, the Bm-W curve data 23, and the number of minor loops to be generated (N_minor_loop).

The information processing apparatus 1 calculates a step size ΔB of the magnetic flux density used for generating the minor loops (S12). For example, the information processing apparatus 1 calculates the step size ΔB of the magnetic flux density by dividing a value Bmax of the maximum magnetic flux density of the major loop data 21 by a value obtained by adding 1 to N_minor_loop indicating the number of minor loops to be generated.

The information processing apparatus 1 initializes an index N indicating which number of minor loop is being generated to "1", and also sets the step size ΔB of the magnetic flux density of the minor loop generated in the first place as the maximum magnetic flux density B₀ (S13).

The information processing apparatus 1 executes the generation processing for the N-th minor loop data (S14). A flowchart of the generation processing for the N-th minor loop data will be described below.

The information processing apparatus 1 determines whether or not the index N is equal to or higher than the N_minor_loop indicating the number of minor loops to be generated (S15). When it is determined that the index N is lower than N_minor_loop (S15; No), the information processing apparatus 1 adds 1 to the index N regarding the minor loop to be generated next, and adds ΔB to the maximum magnetic flux density B₀ (S16). For example, the information processing apparatus 1 sets integral multiples of the step size ΔB of the maximum magnetic flux density, and obtains the maximum magnetic flux density B₀ of the next minor loop. The information processing apparatus 1 proceeds to S14 to generate the next minor loop.

On the other hand, when it is determined that the index N is equal to or higher than N_minor_loop (S15; Yes), the information processing apparatus 1 outputs the minor loop data for the number of N_minor_loop (S17). For example, the information processing apparatus 1 outputs the minor loop data for the number of N_minor_loop saved in the generation processing for the N-th minor loop data. The minor loop generation processing is then ended.

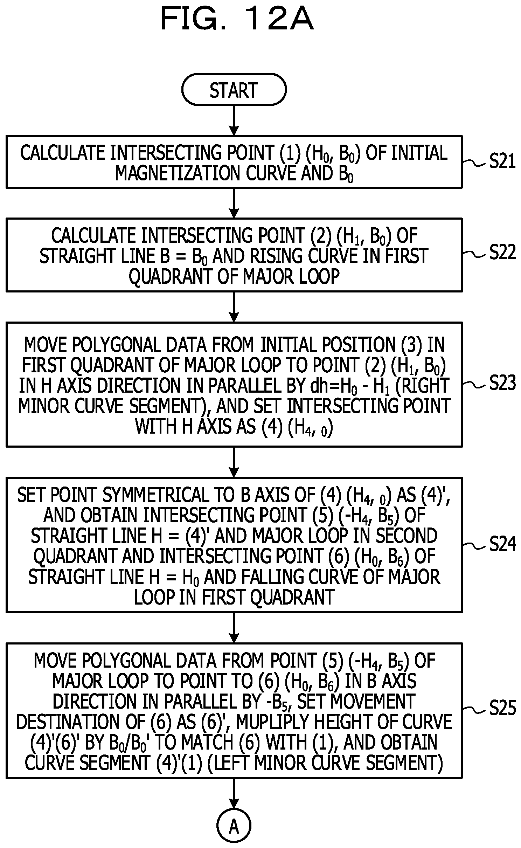

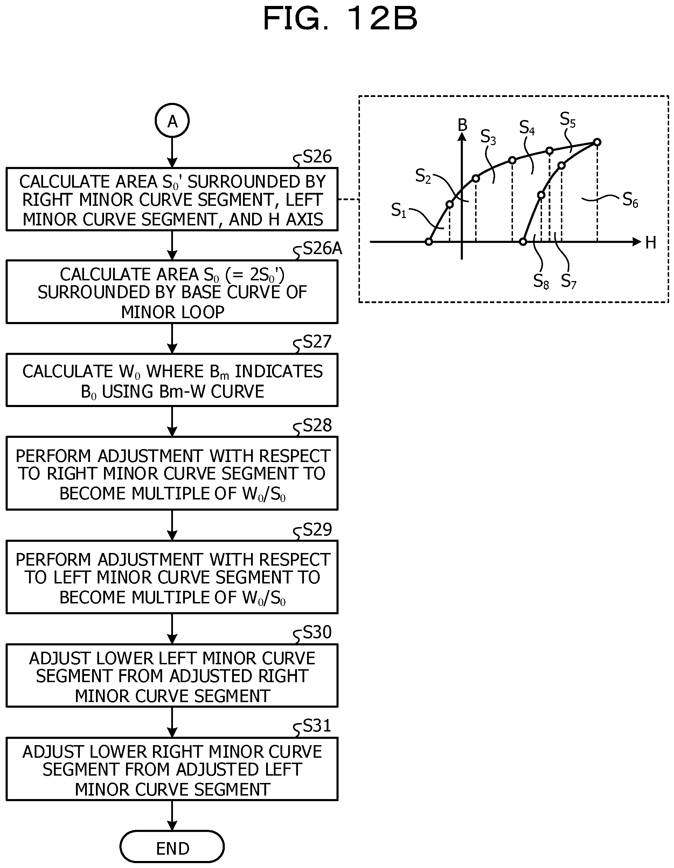

FIGs. 12A and 12B are drawings illustrating an example of the generation processing for the N-th minor loop data. S21 to S23 illustrated in FIG. 12A correspond to FIG. 5. S24 and S25 illustrated in FIG. 12A correspond to FIG. 6. S27 illustrated in FIG. 12A corresponds to FIG. 8. S28 to S31 illustrated in FIG. 12A correspond to FIG. 9.

As illustrated in FIG. 12A, the information processing apparatus 1 calculates an intersecting point (1) (H₀, B₀) of the initial magnetization curve indicated by the initial magnetization curve data 22 and the maximum magnetic flux density B₀ (S21). The information processing apparatus 1 calculates an intersecting point (2) (H₁, B₀) of a straight line where the magnetic flux density B is B₀ and a rising curve in a first quadrant of the major loop indicated by the major loop data 21 (S22).

The information processing apparatus 1 moves polygonal data from an initial position (3) where the magnetic flux density B in the first quadrant of the major loop indicated by the major loop data 21 indicates zero to the point (2) (H₁, B₀) in the H axis direction in parallel by dh (= H₀ - H₁) (S23). As a result, the right minor curve segment is generated. An intersecting point of the right minor curve segment and the H axis (point where the magnetic flux density becomes zero) is set as (4) (H₄, 0).

The information processing apparatus 1 sets a symmetrical point of (4) (H₄, 0) to the B axis is set as (4)' (-H₄, 0). The information processing apparatus 1 obtains an intersecting point (5) (-H₄, B₅) of a straight line where the magnetic field H is (4)' and the major loop in a second quadrant. The information processing apparatus 1 obtains an intersecting point (6) (H₀, B₆) of a straight line where the magnetic field H is H₀ and a falling curve of the major loop in the first quadrant. (S24).

The information processing apparatus 1 moves polygonal data from the point (5) (-H₄, B₅) of the major loop to the point (6) (H₀, B₆) in the B axis direction in parallel by -B₅, and sets a movement destination of the point (6) as (6)' (H₀, B₀'). The information processing apparatus 1 obtains a curve segment (4)' (1) by multiplying the height of the curve (4)' (6)' by B₀/B₀' (S25) such that the point (6)' is matched with the point (1) (H₀, B₀). As a result, the left minor curve segment is generated.

The information processing apparatus 1 calculates an area So' surrounded by the right minor curve segment, the left minor curve segment, and the H axis (S26). For example, as depicted in an auxiliary diagram illustrated in FIG. 12B, the information processing apparatus 1 applies a trapezoid formula to each segment of plural pieces of a series of polygonal data of the right minor curve segment to calculate an area (S₆ + S₇ + S₈) of a region surrounded by the right minor curve segment and the H axis. The information processing apparatus 1 applies the trapezoid formula to each segment of plural pieces of a series of polygonal data of the left minor curve segment to calculate an area (S₁ + S₂ + S₃ + S₄ + S₅) of a region surrounded by the left minor curve segment and the H axis. The information processing apparatus 1 calculates the area So' surrounded by the right minor curve segment, the left minor curve segment, and the H axis as in the following Expression (1). S₀' = (S₁ + S₂ + S₃ + S₄ + S₅) - (S₆ + S₇ + S₈) (1)

The information processing apparatus 1 calculates the area S₀ surrounded by the base curve of the minor loop obtained from the right minor curve segment and the left minor curve segment (S26A). For example, the information processing apparatus 1 calculates the area S₀ as in the following Expression (2). S₀ = 2So' (2)

The information processing apparatus 1 calculates the hysteresis loss W₀ in which Bm indicates the magnetic flux density B₀ using the Bm-W curve indicated by the Bm-W curve data 23 (S27). The hysteresis loss W₀ corresponds to a value of the area of the minor loop which is associated with a value of the amplitude B₀ of the magnetic flux density.

The information processing apparatus 1 performs an adjustment with respect to the right minor curve segment to be a multiple of W₀/S₀ (S28). For example, with respect to the data of the right minor curve segment, the information processing apparatus 1 adjusts a value H_d of the magnetic field of the right minor curve segment using the following Expression (3) and Expression (4) such that a value (H4) of the magnetic field where the magnetic flux density B indicates zero becomes a multiple of W₀/S₀. H_d = (H_d - H₀) × Coef_R + H₀ (3), Coef_R = {H₀ - H₄(W₀/S₀)}/(H₀ - H₄) (4) The information processing apparatus 1 copies the adjusted data to the N-th array. In one example, regarding the right minor curve segment of the N-th minor loop, the number of points is set as N_minor_R. A region of the data of the magnetic field is set as H_minor_R, and a region of the data of the magnetic flux density is set as B_minor_R. The information processing apparatus 1 copies the data of the magnetic field to the array of H_minor_R[N] [1 to N_minor_R]. The information processing apparatus 1 copies the data of the magnetic flux density to the array of B_minor_R[N] [1 to N_minor_R].

The information processing apparatus 1 performs an adjustment with respect to the left minor curve segment to be a multiple of W₀/S₀ (S29). For example, with respect to the data of the left minor curve segment, the information processing apparatus 1 adjusts the value H_d of the magnetic field of the right minor curve segment using the following Expression (5) and Expression (6) such that a value (-H₄) of the magnetic field where the magnetic flux density B indicates zero becomes a multiple of W₀/S₀. H_d = (H_d - H₀) × Coef_L + H₀ (5), Coef_L = {H₀ + H₄(W₀/S₀)}/(H₀ + H₄) (6) The information processing apparatus 1 copies the adjusted data to the N-th array. In one example, regarding the left minor curve segment of the N-th minor loop, the number of points is set as N_minor_L. A region of the data of the magnetic field is set as H_minor_L, and a region of the data of the magnetic flux density is set as B_minor_L. The information processing apparatus 1 copies the data of the magnetic field to the array of H_minor_L[N] [1 to N_minor_L]. The information processing apparatus 1 copies the data of the magnetic flux density to the array of B_minor_L[N] [1 to N_minor_R].

The information processing apparatus 1 generates a lower left minor curve segment from the adjusted right minor curve segment (S30). For example, the information processing apparatus 1 generates data of the lower left minor curve segment by multiplying the data of the right minor curve segment by -1. For example, the information processing apparatus 1 generates a value (-H_minor_R[N], -B_minor_R[N]) obtained by multiplying the data of the right minor curve segment by -1 as the data of the lower left minor curve segment. The information processing apparatus 1 copies the generated data to the N-th array of the lower left minor curve segment.

The information processing apparatus 1 generates a lower right minor curve segment from the adjusted left minor curve segment (S31). For example, the information processing apparatus 1 generates data of the lower right minor curve segment by multiplying the data of the left minor curve segment by -1. For example, the information processing apparatus 1 generates a value (-H_minor_L[N], -B_minor_L[N]) obtained by multiplying the data of the left minor curve segment by -1 as the data of the lower right minor curve segment. The information processing apparatus 1 copies the generated data to the N-th array of the lower right minor curve segment. The information processing apparatus 1 then ends the generation processing for the N-th minor loop data.

### [BH curve including minor loops]

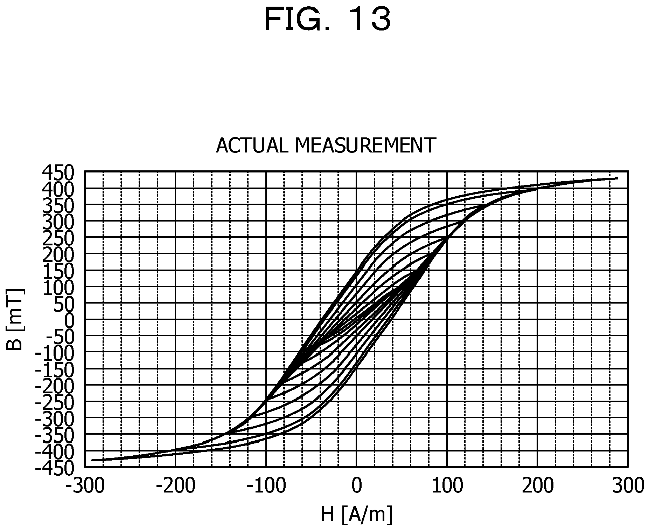

The BH curve including the actually measured minor loops and the actually measured major loop is illustrated in FIG. 13. FIG. 13 is a drawing illustrating the BH curve including the actually measured minor loops (inner loops). As illustrated in FIG. 13, a loop indicated on the outermost side of the BH curve is the actually measured major loop. Loops indicated on the inner side of the BH curve are the actually measured minor loops.

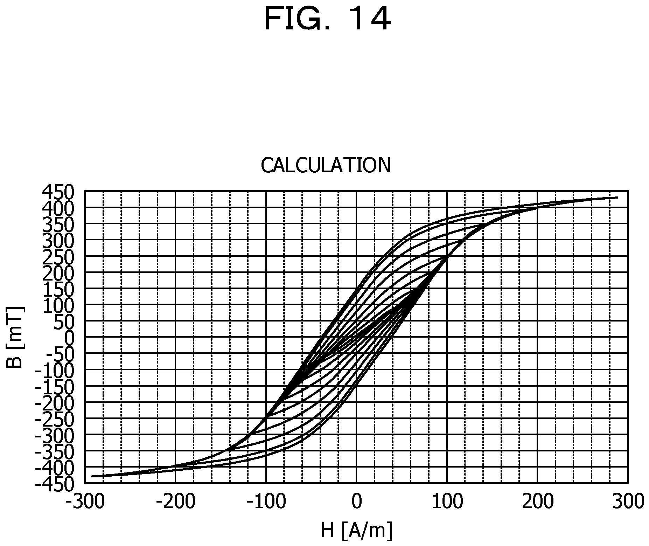

In contrast, a BH curve including the minor loops calculated by the minor loop generation processing according to the embodiment and the actually measured major loop is illustrated in FIG. 14. FIG. 14 is a drawing illustrating the BH curve including the minor loops calculated by the minor loop generation processing according to the embodiment. As illustrated in FIG. 14, a loop indicated on the outermost side of the BH curve is the actually measured major loop. Loops indicated on the inner side of the BH curve are the minor loops calculated by the minor loop generation processing according to the embodiment.

As may be understood from comparison between FIG. 13 and FIG. 14, the minor loops calculated by the minor loop generation processing according to the embodiment are substantially the same as the actually measured minor loops. For example, the minor loop generation processing according to the embodiment may highly accurately reproduce the actually measured minor loops.

### [Advantages of Embodiment]

According to the embodiment, the information processing apparatus 1 inputs the major loop data 21 regarding the hysteresis of the magnetic body, the initial magnetization curve data 22 of the magnetic body, and the Bm-W curve data 23 indicating the relationship between the maximum magnetic flux density of the minor loop regarding the hysteresis and the area of the minor loop associated with the magnetic flux density. The information processing apparatus 1 generates data of the plurality of minor loops using the major loop data 21, the initial magnetization curve data 22, and the Bm-W curve data 23 which have been input. In accordance with the aforementioned configuration, the information processing apparatus 1 may reduce the man hours spent for obtaining the minor loops using the major loop data 21, the initial magnetization curve data 22, and the Bm-W curve data 23.

The information processing apparatus 1 generates a minor loop base curve using the major loop data 21 by setting a point on the initial magnetization curve corresponding to the maximum magnetic flux density of the minor loop to be generated as a peak in the positive region of the minor loop. The information processing apparatus 1 generates the data of the minor loops using the Bm-W curve data 23 such that the area of the closed region surrounded by the generated minor loop base curve becomes the area associated with the maximum magnetic flux density of the minor loops. In accordance with the aforementioned configuration, the information processing apparatus 1 may generate the plurality of minor loops using the major loop data 21, the initial magnetization curve data 22, and the Bm-W curve data 23. As a result, the information processing apparatus 1 may reduce the man hours spent for obtaining the plurality of minor loops.

In response to a specification of a predetermined maximum magnetic flux density of the minor loops to be generated in a region where the magnetic flux density is positive, the information processing apparatus 1 obtains a first point corresponding to the magnetic flux density of the initial magnetization curve and a second point corresponding to the magnetic flux density of the major loop. The information processing apparatus 1 moves a curve linking the second point in the major loop to the point where the magnetic flux density indicates zero in a direction from the second point to the first point in parallel to generate a first base curve of the minor loops. The information processing apparatus 1 obtains a third point obtained by inverting a value of the magnetic field where the magnetic flux density of the first base curve becomes zero and a fourth point corresponding to the value of the magnetic field of the third point in the major loop. The information processing apparatus 1 generates a second base curve of the minor loops by moving the curve linking the fourth point in the major loop to the point corresponding to the value of the magnetic field at the first point in a direction from the fourth point to the third point in parallel, and performing an adjustment such that the end-point as a result of the parallel movement is matched with the first point. The information processing apparatus 1 generates a third base curve in a region where the magnetic flux density is negative by rotating the first base curve and the second base curve by 180 degrees in a point symmetry while the origin is set as the center. The information processing apparatus 1 adjusts each of the curves using the Bm-W curve data 23 such that an area of a closed region obtained from the first base curve, the second base curve, and the third base curve becomes an area corresponding to the predetermined maximum magnetic flux density. In accordance with the aforementioned configuration, the information processing apparatus 1 may generate the plurality of minor loops using the computer. As a result, the information processing apparatus 1 may reduce the man hours spent for obtaining the plurality of minor loops.

The information processing apparatus 1 calculates the step size of the magnetic flux density of the minor loops to be generated by dividing the maximum magnetic flux density of the major loop by a value obtained by adding 1 to the number of the minor loops to be generated. The information processing apparatus 1 calculates the predetermined maximum magnetic flux density of the minor loops obtained by setting an integer multiple of the step size. In accordance with the aforementioned configuration, the information processing apparatus 1 may generate the plurality of minor loops at a high speed by calculating the predetermined maximum magnetic flux density of the minor loops using the step size calculated by the predetermined calculation method.

### [Others]

It is not necessarily demanded that individual components of the illustrated information processing apparatus 1 be physically configured as illustrated. For example, the specific configurations regarding distribution and integration of the information processing apparatus 1 are not limited to the illustrated configuration, and the information processing apparatus 1 may be configured by functionally or physically distributing and integrating all or part of the components in any units, in accordance with various loads, usage states, and the like. For example, the step size calculation unit 11 and the minor loop base curve generation unit 12 may be integrated as a single unit. The minor loop base curve generation unit 12 may be distributed into a first generation unit that generates the right minor curve segment, a second generation unit that generates the left minor curve segment, and a third generation unit that generates the lower right minor curve segment and the lower left minor curve segment. The storage unit 20 may also be coupled via a network as an external apparatus of the information processing apparatus 1.

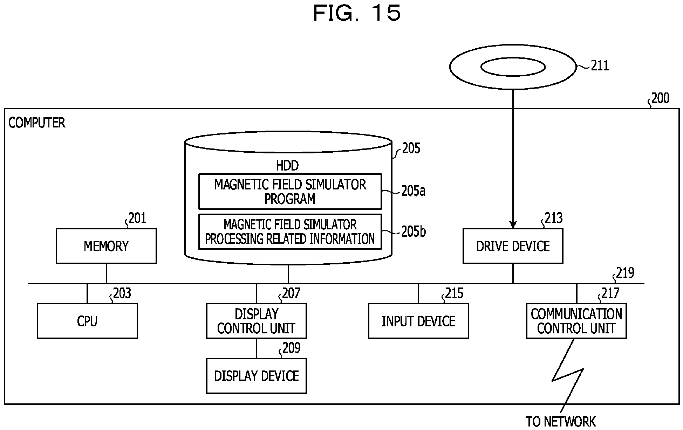

Various processes described according to the above-described embodiment may be realized when a previously prepared program is executed by a computer such as a personal computer or a workstation. Hereinafter, an example of a computer that executes a magnetic field simulator program including minor loop generation processing for realizing similar functions to those of the information processing apparatus 1 illustrated in FIG. 1 will be described. FIG. 15 is a drawing illustrating an example of a computer that executes the magnetic field simulator program.

As illustrated in FIG. 15, a computer 200 includes a CPU 203 that executes various calculation processes, an input device 215 that accepts an input of data from a user, and a display control unit 207 that controls display device 209. The computer 200 further includes a drive device 213 that reads a program from a storage medium, and a communication control unit 217 that exchanges data with another computer via the network. The computer 200 includes a memory 201 that temporarily stores a variety of information, and a hard disk drive (HDD) 205. The memory 201, the CPU 203, the HDD 205, the display control unit 207, the drive device 213, the input device 215, and the communication control unit 217 are coupled to each other by a bus 219.

The drive device 213 is, for example, a device for a removable disk 211. The HDD 205 stores a magnetic field simulator program 205a and magnetic field simulator processing related information 205b.

The CPU 203 reads the magnetic field simulator program 205a to load the program in the memory 201 and executes the program as a process. Such a process corresponds to each of the functional units of the information processing apparatus 1. The magnetic field simulator processing related information 205b corresponds to the major loop data 21, the initial magnetization curve data 22, and the Bm-W curve data 23. For example, the removable disk 211 stores various information such as the magnetic field simulator program 205a.

The magnetic field simulator program 205a may not necessarily have to be stored in the HDD 205 from the beginning. For example, the program may be stored on "portable physical media" including a flexible disk (FD), a compact disk read-only memory (CD-ROM), a digital versatile disk (DVD), a magneto-optical disk, and an IC card to be inserted into the computer 200. The computer 200 may read the magnetic field simulator program 205a from these media and execute the program.

### REFERENCE SIGNS LIST

- 1: Information processing apparatus
- 10: Control unit
- 11: Step size calculation unit
- 12: Minor loop base curve generation unit
- 13: Minor loop base curve adjustment unit
- 14: BH curve output unit
- 20: Storage unit
- 21: Major loop data
- 22: Initial magnetization curve data
- 23: Bm-W curve data

## Claims

1. An information processing apparatus comprising:
an input unit configured to input data of major loop regarding a hysteresis of a magnetic body, data of an initial magnetization curve of the magnetic body, and a relationship between a maximum magnetic flux density of a minor loop regarding the hysteresis and an area of the minor loop associated with the magnetic flux density; and
a generation unit configured to generate data of a plurality of the minor loops using the data of the major loop, the initial magnetization curve, and the relationship between the maximum magnetic flux density of the minor loop regarding the hysteresis and the area of the minor loop associated with the magnetic flux density which have been input by the input unit.

2. The information processing apparatus according to claim 1,
wherein the generation unit is configured to generate the data of the minor loops by setting a point on the initial magnetization curve corresponding to the maximum magnetic flux density of the minor loop to be generated as a peak in a positive region of the minor loop, and generating a base curve of the minor loop using the data of the major loop, in a manner that an area of a closed region surrounded by the generated base curve of the minor loop becomes the area associated with the maximum magnetic flux density of the minor loop using the relationship.

3. The information processing apparatus according to claim 2, wherein the generation unit includes:
a first generation unit configured to generate, in response to a specification of a predetermined maximum magnetic flux density of the minor loops to be generated in a region where the magnetic flux density is positive, a first base curve of the minor loop by obtaining a first point corresponding to the magnetic flux density of the initial magnetization curve and a second point corresponding to the magnetic flux density of the major loop, and moving a curve linking the second point in the major loop to a point where the magnetic flux density indicates zero in a direction from the second point to the first point in parallel,
a second generation unit configured to generate a second base curve of the minor loop by obtaining a third point obtained by inverting a value of the magnetic field where the magnetic flux density of the first base curve becomes zero and a fourth point corresponding to the value of the magnetic field of the third point in the major loop, moving a curve linking the fourth point in the major loop to a point corresponding to the value of the magnetic field at the first point in a direction from the fourth point to the third point in parallel, and performing an adjustment in a manner that an end-point as a result of the parallel movement is matched with the first point,
a third generation unit configured to generate a third base curve in a region where the magnetic flux density is negative by rotating the first base curve and the second base curve by 180 degrees in a point symmetry while an origin is set as a center, and
an adjustment unit configured to adjust each of the curves using the relationship in a manner that an area of a closed region obtained from the first base curve, the second base curve, and the third base curve becomes an area corresponding to the predetermined maximum magnetic flux density.

4. The information processing apparatus according to claim 2 or 3, wherein
a step size of the magnetic flux density of the minor loops to be generated is calculated by dividing the maximum magnetic flux density of the major loop by a value obtained by adding 1 to the number of the minor loops to be generated, and the predetermined maximum magnetic flux density of the minor loops obtained by setting an integer multiple of the step size is calculated.

5. A magnetic field simulator method executed by a computer, the magnetic field simulator method comprising:
inputting data of major loop regarding a hysteresis of a magnetic body, data of an initial magnetization curve of the magnetic body, and a relationship between a maximum magnetic flux density of a minor loop regarding the hysteresis and an area of the minor loop associated with the magnetic flux density, and
generating data of a plurality of the minor loops using the data of the major loop, the initial magnetization curve, and the relationship between the maximum magnetic flux density of the minor loop regarding the hysteresis and the area of the minor loop associated with the magnetic flux density.

6. The magnetic field simulator method according to claim 5, wherein the generating includes
generating the data of the minor loops by setting a point on the initial magnetization curve corresponding to the maximum magnetic flux density of the minor loop to be generated as a peak in a positive region of the minor loop, and generating a base curve of the minor loop using the data of the major loop, in a manner that an area of a closed region surrounded by the generated base curve of the minor loop becomes the area associated with the maximum magnetic flux density of the minor loop using the relationship.

7. The magnetic field simulator method according to claim 6, wherein the generating includes:
generating, in response to a specification of a predetermined maximum magnetic flux density of the minor loops to be generated in a region where the magnetic flux density is positive, a first base curve of the minor loop by obtaining a first point corresponding to the magnetic flux density of the initial magnetization curve and a second point corresponding to the magnetic flux density of the major loop, and moving a curve linking the second point in the major loop to a point where the magnetic flux density indicates zero in a direction from the second point to the first point in parallel,
generating a second base curve of the minor loop by obtaining a third point obtained by inverting a value of the magnetic field where the magnetic flux density of the first base curve becomes zero and a fourth point corresponding to the value of the magnetic field of the third point in the major loop, moving a curve linking the fourth point in the major loop to a point corresponding to the value of the magnetic field at the first point in a direction from the fourth point to the third point in parallel, and performing an adjustment in a manner that an end-point as a result of the parallel movement is matched with the first point,
generating a third base curve in a region where the magnetic flux density is negative by rotating the first base curve and the second base curve by 180 degrees in a point symmetry while an origin is set as a center, and
adjusting each of the curves using the relationship in a manner that an area of a closed region obtained from the first base curve, the second base curve, and the third base curve becomes an area corresponding to the predetermined maximum magnetic flux density.

8. The magnetic field simulator method according to claim 6 or 7, wherein the generating includes:
calculating a step size of the magnetic flux density of the minor loops to be generated by dividing the maximum magnetic flux density of the major loop by a value obtained by adding 1 to the number of the minor loops to be generated, and
calculating the predetermined maximum magnetic flux density of the minor loops obtained by setting an integer multiple of the step size.

9. A magnetic field simulator program that causes a computer to executed a process, the process comprising:
inputting data of major loop regarding a hysteresis of a magnetic body, data of an initial magnetization curve of the magnetic body, and a relationship between a maximum magnetic flux density of a minor loop regarding the hysteresis and an area of the minor loop associated with the magnetic flux density, and
generating data of a plurality of the minor loops using the data of the major loop, the initial magnetization curve, and the relationship between the maximum magnetic flux density of the minor loop regarding the hysteresis and the area of the minor loop associated with the magnetic flux density.

10. The magnetic field simulator program according to claim 9, wherein the generating includes
generating the data of the minor loops by setting a point on the initial magnetization curve corresponding to the maximum magnetic flux density of the minor loop to be generated as a peak in a positive region of the minor loop, and generating a base curve of the minor loop using the data of the major loop, in a manner that an area of a closed region surrounded by the generated base curve of the minor loop becomes the area associated with the maximum magnetic flux density of the minor loop using the relationship.

11. The magnetic field simulator program according to claim 10, wherein the generating includes:
generating, in response to a specification of a predetermined maximum magnetic flux density of the minor loops to be generated in a region where the magnetic flux density is positive, a first base curve of the minor loop by obtaining a first point corresponding to the magnetic flux density of the initial magnetization curve and a second point corresponding to the magnetic flux density of the major loop, and moving a curve linking the second point in the major loop to a point where the magnetic flux density indicates zero in a direction from the second point to the first point in parallel,
generating a second base curve of the minor loop by obtaining a third point obtained by inverting a value of the magnetic field where the magnetic flux density of the first base curve becomes zero and a fourth point corresponding to the value of the magnetic field of the third point in the major loop, moving a curve linking the fourth point in the major loop to a point corresponding to the value of the magnetic field at the first point in a direction from the fourth point to the third point in parallel, and performing an adjustment in a manner that an end-point as a result of the parallel movement is matched with the first point,
generating a third base curve in a region where the magnetic flux density is negative by rotating the first base curve and the second base curve by 180 degrees in a point symmetry while an origin is set as a center, and
adjusting each of the curves using the relationship in a manner that an area of a closed region obtained from the first base curve, the second base curve, and the third base curve becomes an area corresponding to the predetermined maximum magnetic flux density.

12. The magnetic field simulator program according to claim 10 or 11, wherein the generating includes:
calculating a step size of the magnetic flux density of the minor loops to be generated by dividing the maximum magnetic flux density of the major loop by a value obtained by adding 1 to the number of the minor loops to be generated, and
calculating the predetermined maximum magnetic flux density of the minor loops obtained by setting an integer multiple of the step size.
